# FASCICULE DE BREVET EUROPEEN

(11) **EP 1 260 821 B1**
(45) Date de publication et mention de la délivrance du brevet: **30.11.2005**
(21) Numéro de dépôt: 02354072.7
(22) Date de dépôt: 29.04.2002
(51) Int. Cl.: G01R 29/20, G01R 15/18

(54) **Transformateur de détection pour dispositif de protection différentielle et dispositif de protection comportant un tel transformateur**
Detektionswandler für einen Differentialschutz und mit einem solchen Wandler versehene Schutzeinrichtung
Detectiont transformer for a differential protection device and protection device using such a transformer

(30) Priorité: 21.05.2001 FR 0106674
(43) Date de publication de la demande: 27.11.2002
(73) Titulaire: SCHNEIDER ELECTRIC INDUSTRIES SAS, 92500 Rueil-Malmaison (FR)
(72) Inventeur: Juraszek, Christelle, 38050 Grenoble cedex 09 (FR); Paupert, Marc, 38050 Grenoble cedex 09 (FR); Tian, Simon, 38050 Grenoble cedex 09 (FR)
(74) Mandataire: Tripodi, Paul

(56) Documents cités:
- EP-A- 0 427 412
- EP-A- 0 651 258
- EP-A- 0 936 716
- US-A- 4 529 931
- US-A- 4 881 989
- US-A- 5 969 930
- PATENT ABSTRACTS OF JAPAN vol. 013, no. 564 (E-860), 14 décembre 1989 (1989-12-14) & JP 01 235213 A (HITACHI METALS LTD), 20 septembre 1989 (1989-09-20)

## Description

### DOMAINE TECHNIQUE

L'invention concerne un dispositif de protection différentielle sensible à un courant de défaut différentiel alternatif, continu ou périodique, comportant :
- un transformateur de détection de courant de défaut différentiel en forme de tore comportant au moins un enroulement secondaire,
- un circuit d'excitation connecté audit au moins un enroulement secondaire dudit transformateur de détection pour appliquer des signaux d'excitation,
- un circuit de traitement connecté à l'enroulement secondaire, et
- un circuit d'alimentation connecté au circuit d'excitation et au circuit de traitement.

### ETAT DE LA TECHNIQUE

Il existe des dispositifs de protection différentielle comportant un transformateur de détection en forme de tore pouvant détecter des courants de défaut alternatifs. Ces dispositifs fonctionnent soit à propre courant ou avec une alimentation auxiliaire en tension. Ces dispositifs permettent de déclencher l'ouverture de contacts pour couper la fourniture de courant électrique à une portion de réseau électrique à protéger. Des dispositifs de protection différentielle à propre courant sont décrits dans les documents US5969930 et EP0936716.

Lorsqu'un courant continu ou une composante continue d'un courant de défaut doivent être aussi détectés, les dispositifs de protection comportent des circuits de traitement pour mesurer un décalage de la magnétisation du tore de mesure. De manière connue, le décalage est mesuré en utilisant des circuits d'excitation pour injecter un signal d'excitation à un ou plusieurs enroulements du tore. La fourniture du signal d'excitation du tore nécessite une alimentation électrique des circuits électroniques et de l'enroulement.

Un brevet EP356344B1 décrit un dispositif de protection différentielle sensible à un courant de défaut alternatif, continu, ou périodique. Ce dispositif comporte deux enroulements secondaires excités en alternance par un circuit d'excitation. Le signal de défaut est mesuré en utilisant des durées d'intégration dépendantes du décalage du champ magnétique induit par un courant de défaut différentiel et de la saturation du circuit magnétique. Une demande de brevet EP0651258 décrit un autre mode de réalisation d'un capteur de courant à saturation de circuit magnétique.

Un brevet US4276510 divulgue un appareil pour détecter un courant de défaut différentiel avec un transformateur en forme de tore. Dans cet appareil, un circuit de traitement permet de renvoyer sur le tore un courant de retour ou de compensation pour compenser le décalage provoqué par un courant de défaut. Dans ce cas, puisque le courant de compensation est directement proportionnel au courant de défaut, un signal de mesure dépendant du courant de compensation est fourni pour le traitement du défaut. Il excite aussi des capteurs de mesure de courants continus à excitation et retour de compensation décrits dans les documents US4529931 et EP0427412.

Un brevet US 4 881 989 divulgue un alliage magnétique à base de fer.

Les dispositifs de l'état de la technique comportent des tores ayant des caractéristiques magnétiques présentant des pertes importantes dès que la fréquence du signal d'excitation augmente. Si le matériau du tore est de type ferrite la fréquence d'excitation peut être élevée mais le champ coercitif est élevé pour une induction de saturation suffisante à la mesure de courant différentiel. Des matériaux magnétiques doux connus ont des champs coercitifs faibles mais ont un mauvais fonctionnement en fréquence. De plus, ces matériaux magnétiques doux ont des cycles de magnétisation très arrondis et ne permettent pas de détecter une saturation de la magnétisation. D'autres matériaux doux connus présentent un cycle d'hystérésis rectangulaire mais leur champ coercitif est trop élevé. D'autres matériaux à forte proportion de cobalt ne sont pas stables lors de variations de température, provoquent des pertes en fréquence trop élevées et impliquent une augmentation de l'alimentation des circuits d'excitation.

Par conséquent, pour exciter des tores de l'état de la technique, des circuits d'excitation sont alimentés avec une énergie électrique importante. Cette situation conduit à des circuits d'alimentation volumineux peu compatibles avec des appareils de protection modulaires de faibles dimensions. De plus, une énergie électrique importante pour l'excitation provoque un échauffement important des dispositifs de protection. L'utilisation d'énergie importante signifie aussi que la mesure de très faibles courants de défaut n'est pas très précise.

### EXPOSE DE L'INVENTION

L'invention a pour but un transformateur de détection de défaut différentiel en forme de tore permettant une réduction importante de l'énergie électrique d'excitation et une amélioration de la sensibilité pour de faibles courants de défaut, et un dispositif de protection différentielle comportant un circuit d'alimentation et un tel transformateur.

Un dispositif de protection différentielle selon l'invention est défini dans la revendication 1

Les caractéristiques en statique correspondent notamment à des caractéristiques en courant continu ou ayant des variations lentes.

De préférence, le cycle rectangulaire est tel que le rapport entre une induction à champ nul sur une induction de saturation est supérieur à 0,95.

Avantageusement, le champ coercitif est inférieur à 1,5 Ampères par mètre en statique ou en basse fréquence.

De préférence, le circuit magnétique du transformateur a un rapport champ coercitif sur induction à champ nul tel que le champ coercitif est inférieur à 3A/m pour une induction à champ nul supérieure à 1 Tesla.

Dans un mode de réalisation préférentiel, la variation de l'induction du circuit magnétique du transformateur, en statique ou à une fréquence inférieure à 400Hz, est supérieure à 2 Teslas pour un champ magnétique inférieur à 3 Ampères par mètre (3 A/m).

Avantageusement, la variation de l'induction du circuit magnétique du transformateur, en statique ou à une fréquence inférieure à 400Hz, est supérieure à 2,4 Teslas pour un champ magnétique inférieur à 2,5 Ampères par mètre (2,5 A/m).

Avantageusement, le circuit magnétique du transformateur a un champ magnétique inférieur à 20 Ampères par mètre (20 A/m) à induction nulle à une fréquence de trois kilohertz.

Dans un mode de réalisation particulier, le circuit magnétique est obtenu par un traitement thermique sous un champ magnétique.

De préférence, le matériau du circuit magnétique comporte plus de 50% de grains à fins cristaux ayant une grosseur de grains inférieure à 100nm.

Avantageusement, le matériau du circuit magnétique est réalisé par des bandes de matériaux ayant une épaisseur inférieure à 30 micromètres (µm).

De préférence, le transformateur comporte un support pour maintenir le matériau magnétique.

De préférence le matériau magnétique est enroulé en bandes sur le support, les bandes formant un circuit magnétique d'épaisseur inférieure à un millimètre

Avantageusement, le circuit magnétique est constitué par au moins une rondelle de matériau magnétique.

De préférence, le circuit d'excitation comporte des moyens pour injecter dans l'enroulement secondaire un courant de forme triangulaire, une excitation correspondant à une amplitude de crête dudit courant et à un nombre de spires de l'enroulement étant inférieure à 3,5 ampère-tours.

Avantageusement, le circuit d'alimentation fournit au circuit d'excitation et à l'enroulement secondaire une puissance inférieure à 1 Watt.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma d'un dispositif de protection différentielle de l'art antérieur;
- la figure 2 représente un schéma bloc d'un dispositif de protection pouvant comporter un transformateur de détection selon un mode de réalisation de l'invention ;
- la figure 3 représente un schéma bloc détaillé d'un dispositif de protection pouvant comporter un transformateur de détection selon un mode de réalisation de l'invention ;
- les figures 4A à 4D illustrent des signaux d'un dispositif de protection pouvant comporter un transformateur de détection selon un mode de réalisation de l'invention ;
- le figure 5 représente des cycles de magnétisation d'un transformateur de détection de courant de défaut différentiel selon un mode de réalisation de l'invention ;
- la figure 6 représente des cycles de magnétisation d'un transformateur de détection de courant de défaut différentiel selon un mode de réalisation de l'invention et de transformateurs de l'art antérieur ;
- la figure 7 représente une courbe normalisée de l'induction en fonction du champ magnétique d'un transformateur de détection selon un mode de réalisation de l'invention ;
- la figure 8 représente des courbes normalisées de l'induction en fonction du champ magnétique d'un transformateur de détection de courant de défaut différentiel selon un mode de réalisation de l'invention et de transformateurs de l'art antérieur ; et
- la figure 9 représente un circuit magnétique d'un transformateur selon un mode de réalisation de l'invention comportant un support.

### DESCRIPTION DETAILLEE DE MODES DE REALISATION PREFERES

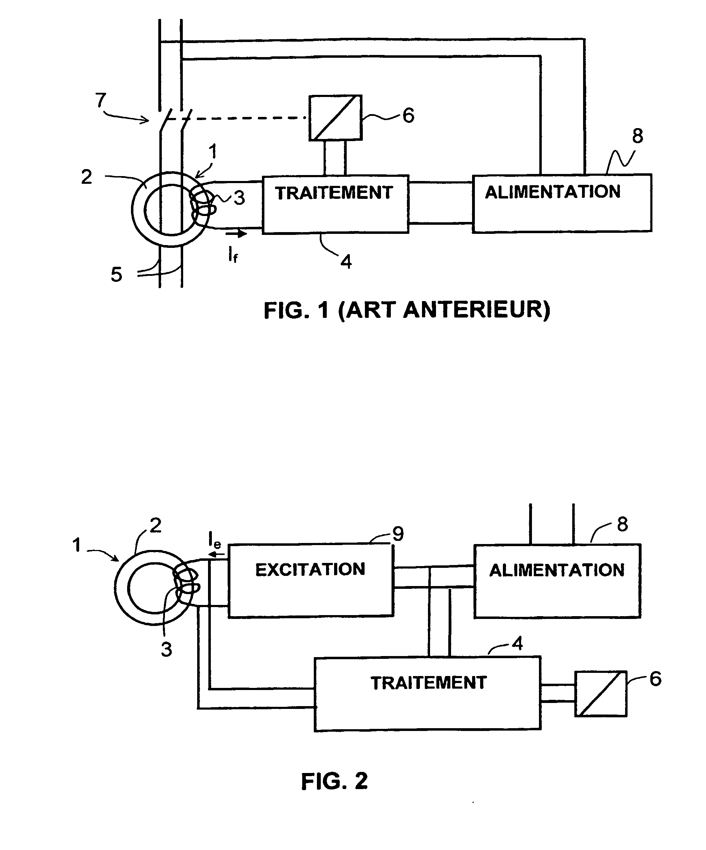

Le dispositif de protection différentielle représenté sur la figure 1, comporte un transformateur 1 de détection de courant de défaut différentiel comportant un circuit magnétique 2 en forme de tore et un enroulement secondaire 3 connecté à un circuit 4 de traitement. Le transformateur 1 entoure des conducteurs 5 d'un réseau ou d'une portion de réseau à protéger. Le circuit 4 de traitement reçoit un signal de mesure du transformateur 1 et commande l'ouverture d'un relais 6 de déclenchement pour déclencher l'ouverture de contacts électriques 7 disposés en série avec les conducteurs 5. Lorsque le dispositif de protection ne fonctionne pas à propre courant, un circuit d'alimentation 8 disposé entre des lignes d'alimentation et le circuit 4 fournit l'énergie nécessaire à la mesure et au traitement d'un signal If représentatif du courant de défaut différentiel.

Si un courant de défaut différentiel est un courant continu, pulsé, ou présente une composante continue, un circuit d'excitation est utilisé pour exciter un enroulement du transformateur de courant. Sur le schéma de la figure 2, un circuit 9 d'excitation est connecté à l'enroulement secondaire 3 pour fournir un signal d'excitation Ie. Le circuit 9 d'excitation est aussi connecté au circuit d'alimentation 8 pour recevoir l'énergie nécessaire à l'excitation de l'enroulement 3. Selon le type de circuit magnétique cette énergie peut être élevée et rendre le dispositif de protection trop volumineux pour des appareils de type modulaire de faibles dimensions.

Avec des caractéristiques particulières du circuit magnétique 2 du transformateur selon un mode de réalisation de l'invention, le circuit d'excitation peut fournir une énergie d'excitation très réduite même à des fréquences élevées très supérieures à une fréquence nominale du réseau électrique à protéger. De plus un transformateur de courant selon l'invention permet la détection de courants alternatifs et continus de très haute précision et de très faibles valeurs, par exemple de quelques milliampères. Avantageusement, le circuit magnétique du transformateur a un cycle rectangulaire avec un champ coercitif faible, de faibles pertes en fréquence, et une bonne stabilité en température.

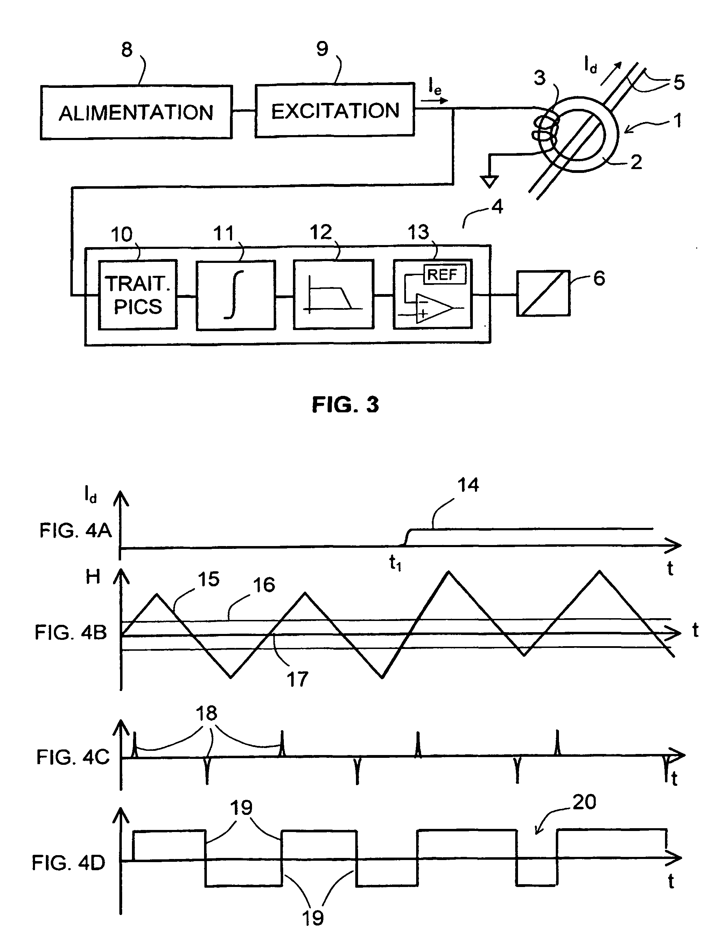

Le schéma bloc de la figure 3 représente un dispositif de protection différentielle comportant le circuit d'alimentation 8 alimentant un circuit d'excitation 9 pour fournir un signal d'excitation Ie à un enroulement 3 d'un transformateur de détection 1. Le circuit magnétique 2 du transformateur ayant des caractéristiques magnétiques particulières, l'énergie électrique fournie par le circuit d'excitation est basse et le circuit d'alimentation peut être réduit. De préférence, le circuit 9 injecte dans l'enroulement 3 un signal d'excitation sous la forme d'un courant triangulaire. De préférence, l'excitation crête de l'enroulement 3 est inférieure à 3,5 Ampères tours en valeur crête, pour une protection contre des courants différentiels de 30mA. Par exemple, un courant crête inférieur à 70 milliampères pour un enroulement de 50 spires. Pour d'autres valeurs de protection, des caractéristiques des valeurs du circuit magnétique et de l'excitation peuvent être différentes. La puissance fournie pour l'excitation peut être alors inférieure à un Watt.

Dans le circuit de traitement 4, un module 10 de détection de saturation détecte et traite des pics de signal représentatifs du dépassement de la saturation du circuit magnétique. Le module 10 détermine des intervalles de temps entre les pics et fournit, par exemple, un signal rectangulaire dont le rapport cyclique est dépendant des instants d'apparition des pics ou de dépassements de coudes de saturation du circuit magnétique dans un premier sens puis dans un second sens opposé. Le signal fourni par le module 10 est appliqué à une entrée d'un module 11 d'intégration. A la sortie du module d'intégration un module de filtrage reçoit un signal d'intégration et fournit un signal filtré à un module de comparaison 13. Le signal filtré est alors comparé à un seuil de référence. Si ledit seuil est dépassé le module 13 commande le relais 6 de déclenchement.

Les figures 4A à 4D illustrent des signaux d'un dispositif de protection différentielle, comportant un transformateur selon un mode de réalisation de l'invention. La figure 4A représente une courbe montrant l'apparition d'un courant de défaut différentiel Id à un instant t1. La figure 4B représente une courbe 15 montrant un champ magnétique H produit dans le circuit magnétique par le courant d'excitation de l'enroulement le et par le courant de défaut différentiel. Des limites 16 et 17 montrent le dépassement d'un coude de saturation du circuit magnétique. La fréquence des signaux triangulaires est de préférence très supérieure à la fréquence d'un réseau à protéger, par exemple une fréquence d'excitation de 300Hz à quelques kHz. Sur la figure 4C, une courbe 18 représente des pics représentatifs du dépassement de l'induction de saturation. Des tels pics peuvent être détectés et traités par un module 10. La figure 4D montre des signaux rectangulaires déclenchés par les pics 18. Pour un bon fonctionnement à ces fréquences, le cycle de magnétisation est sensiblement rectangulaire pour présenter un changement d'état magnétique brusque, et le champ magnétique à induction nulle est avantageusement très faible.

En absence de courant de défaut avant l'instant tl les seuils de saturation sont dépassés à des intervalles réguliers. Ainsi les pics 18 sont aussi à intervalles réguliers et le signal rectangulaire 19 a un cycle où des parties positives et négatives sont sensiblement de durées égales. A partir de l'instant tl, un courant de défaut Id représenté sur la courbe 14 décale le champ magnétique produit par l'excitation en courant triangulaire sur l'enroulement 3. Le décalage se répercute sur les dépassements de l'induction de saturation et les impulsions sont par conséquent décalées dans le temps. Le décalage des impulsions produit un signal rectangulaire avec des parties positives et négatives de durées inégales dépendantes de la valeur du courant de défaut différentiel. Ces durées inégales sont représentées sur la partie 20 de la courbe 19 après l'instant tl.

Pour pouvoir réduire la puissance de l'alimentation électrique, le circuit magnétique est réalisé par exemple en matériau magnétique nanocristallin, ou amorphe ayant des caractéristiques statiques telles que le cycle de magnétisation est sensiblement rectangulaire avec un champ coercitif inférieur à 3A/m.

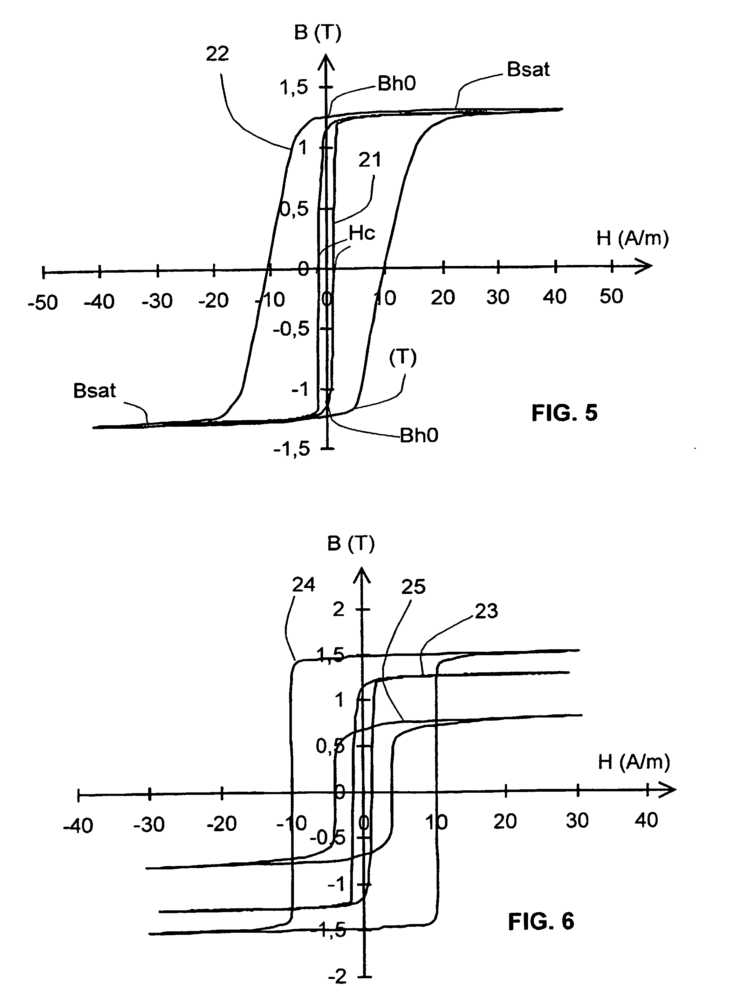

La figure 5 montre des cycles de magnétisation d'un transformateur de détection de courant différentiel selon un mode de réalisation de l'invention. Un cycle 21 en statique ou à basse fréquence est tel que le champ coercitif Hc permettant de ramener l'induction à 0 Tesla est inférieur à 3 ampères par mètre (A/m), de préférence inférieur à 1,5 A/m. L'induction à champ nul Bh0 et l'induction Bsat à la saturation du circuit magnétique sont, de préférence, supérieures à un tesla. Le cycle rectangulaire est avantageusement à coudes prononcés. Les caractéristiques rectangulaires du cycle peuvent être, de préférence, telle que le rapport d'une induction rémanente ou induction à champ nul sur une induction de saturation Bsat est supérieur à 95% pour une fréquence de 50 Hz. Pour un cycle 22, à une fréquence de 300 Hz, le champ à induction nulle est inférieur à 11 A/m et l'induction à champ nul est supérieure à 1,2 Tesla.

Avantageusement le gain correspondant à la variation de champ magnétique sur la variation d'induction (ΔB/ΔH) est supérieur à 200%. Ce gain est déterminé notamment selon la méthode (CCFR) "Constant Current Flux Reset" normalisée aux Etats Unis d'Amérique sous le numéro ASTM A598.

La figure 6 montre des cycles comparatifs en statique ou quasi-statique entre un cycle 23 d'un transformateur de détection selon un mode de réalisation de l'invention et des cycles 24 et 25 de magnétisation de tores de mesure de l'état de la technique. Le cycle 23 a une forme rectangulaire avec un champ coercitif faible inférieur à 3 A/m et une induction à champ nul supérieure à 1 tesla pour réduire l'énergie d'excitation du circuit magnétique. Le cycle 24 présente un cycle rectangulaire mais un champ coercitif élevé de l'ordre de 10 A/m. Dans ce cas il faut une énergie d'excitation importante pour mesurer un courant de défaut différentiel. Dans le cycle 25, le champ coercitif est un peu réduit mais la forme arrondie du cycle ne permet pas d'utiliser correctement le principe de l'excitation pour mesurer un courant de défaut. Le cycle 23 correspond à un matériau magnétique pour la mesure de courants alternatifs à propre courant et à basse fréquence. Un tel cycle 25 n'est pas facilement utilisable pour des dispositifs à excitation.

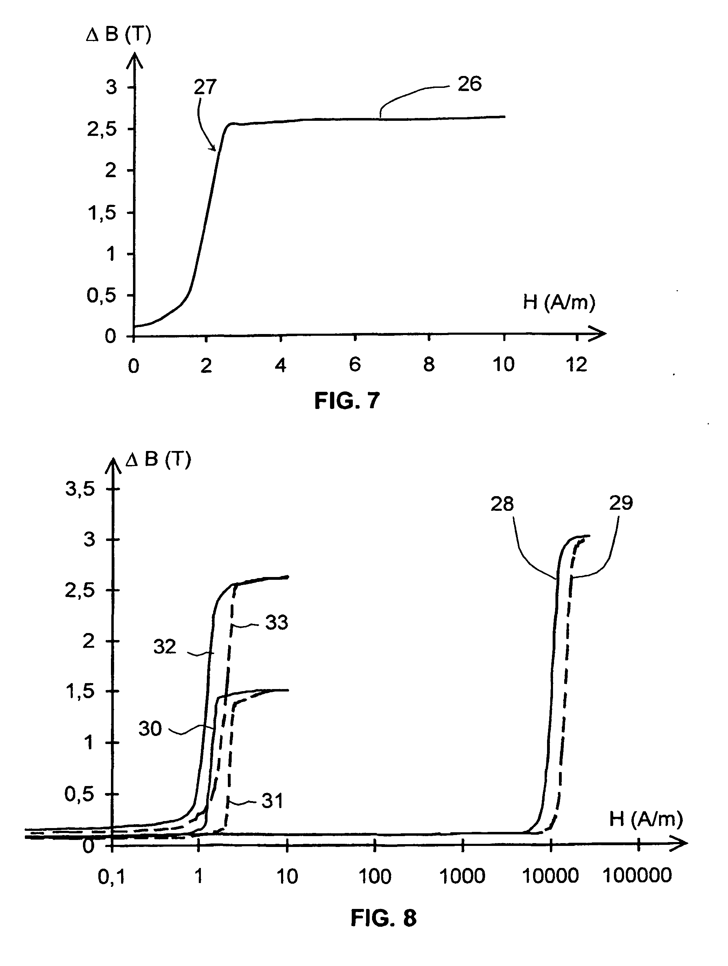

La figure 7 montre une courbe 26 illustrant la variation d'induction d'un transformateur de détection pour un dispositif de protection différentielle selon un mode de réalisation de l'invention, définie à 300Hz selon la méthode CCFR . Sur cette figure, une partie 27 de la courbe a une variation d'induction supérieure à 2 teslas pour un champ inférieur à 3 A/m. Par exemple, dans une portion de courbe où le champ est supérieur à 2,4 A/m la variation d'induction est avantageusement supérieure à 2,5 teslas.

Un circuit magnétique d'un transformateur selon un mode de réalisation de l'invention a une réponse en fréquence très élevée. Par exemple, à une fréquence de 3 kHz, le circuit magnétique du transformateur a un champ magnétique inférieur à 20 Ampères par mètre (20 A/m) à induction nulle.

Sur la figure 8 des courbes comparatives permettent d'illustrer les différences entre des circuits magnétiques de l'état de la technique et un circuit magnétique selon un mode de réalisation de l'invention. Des courbes 28 et 29 montrent des variations d'induction magnétique en fonction d'un champ magnétique respectivement à 50 Hz et 400Hz d'un matériau pour un transformateur ayant un cycle selon la courbe 24 de la figure 6. La variation élevée de l'induction indique un cycle sensiblement rectangulaire mais pour des valeurs de champs très élevées. Un tel matériau magnétique a un champ coercitif ou un champ à induction nulle très élevé ce qui implique une consommation très élevée d'énergie d'excitation. Des courbes 30 et 31 montrent des variations d'induction magnétique d'un matériau pour un transformateur ayant un cycle selon la courbe 25 de la figure 6 respectivement à 50Hz et 400 Hz. Le champ est faible mais la faible variation d'induction ne permet pas une détection facile et précise d'un courant différentiel par un dispositif à excitation. Des courbes 32 et 33 montent des variations d'induction magnétique en fonction d'un champ magnétique respectivement à 50 Hz et 400 Hz d'un circuit magnétique d'un transformateur selon un mode réalisation de l'invention. Un tel transformateur cumule les caractéristiques d'un cycle rectangulaire et d'un faible champ coercitif ou à induction nulle.

Un matériau du circuit magnétique selon un mode de réalisation de l'invention peut être de type nanocristalin ou amorphe. De préférence, le matériau peut aussi être un alliage magnétique doux à base de fer, dont la structure est constituée à plus de 50% de grains à fins cristaux ayant une grosseur de grains inférieure à 100nm. Le circuit magnétique du transformateur de détection est, de préférence, obtenu par traitement thermique de quelques centaines de degrés Celsius, sous champ magnétique d'un tore formé à partir d'un ruban enroulé.

Pour réduire les pertes en fréquence dues aux courants de Foucault, le circuit magnétique est réalisé par une bande de matériau magnétique ayant une épaisseur inférieure à 30 µm.

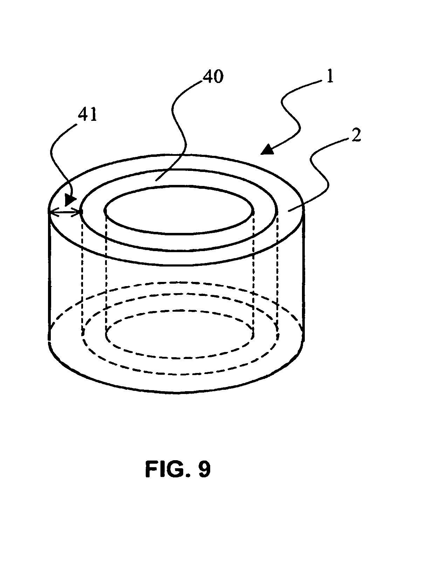

La figure 9 montre un transformateur de détection de courant comportant un support 40 pour maintenir le matériau magnétique. Par exemple, le matériau magnétique est enroulé en bandes sur le support 40, le rouleau de bandes formant un circuit magnétique 2 d'épaisseur 41 inférieure à un millimètre (mm). Avantageusement, l'épaisseur du circuit magnétique enroulé est de 0,5 millimètre. Le support 40 est de préférence en matériau non magnétique. Il confère au circuit magnétique une bonne tenue mécanique même si la quantité de matériau magnétique est réduite.

Le circuit magnétique peut aussi être avantageusement réalisé par une ou plusieurs rondelles de matériau magnétique tel que défini ci-dessus. Ces rondelles peuvent notamment être réalisées par poinçonnage ou par découpe.

Le dispositif décrit ci-dessus est un exemple de réalisation. D'autres schémas de dispositifs peuvent convenir pour mettre en oeuvre l'invention.

Les modes de réalisations du transformateur de détection décrits ci-dessus sont des modes de réalisation préférés. Cependant, d'autres façons de réaliser le transformateur pourraient convenir.

## Revendications

1. Dispositif de protection différentielle sensible à un courant de défaut différentiel alternatif, continu ou périodique comportant :
- un transformateur (1) de détection de courant de défaut différentiel en forme de tore comportant un circuit magnétique et au moins un enroulement (3) secondaire pour recevoir des signaux d'excitation destinés à la détection de courant de défaut différentiel par décalage de champ magnétique du circuit magnétique,
- un circuit d'excitation (9) connecté audit au moins un enroulement secondaire dudit transformateur de détection pour appliquer lesdits signaux d'excitation,
- un circuit (4) de traitement connecté à l'enroulement secondaire et au circuit d'excitation, et
- un circuit (8) d'alimentation connecté au circuit d'excitation et au circuit de traitement,
dispositif **caractérisé en ce que** le circuit magnétique du transformateur est réalisé en matériau magnétique à base de fer ayant des cristaux de grosseur inférieure à 100nm, ledit matériau magnétique ayant, en statique ou en basse fréquence, un cycle (21, 23) de magnétisation sensiblement rectangulaire et un champ coercitif (Hc) inférieur à 3 Ampères par mètre.

2. Dispositif de protection différentielle selon la revendication 1 **caractérisé en ce que** le cycle (21, 23) rectangulaire du circuit magnétique est tel que le rapport entre une induction à champ nul (Bh0) sur une induction de saturation (Bsat) est supérieur à 0,95.

3. Dispositif de protection différentielle selon l'une des revendications 1 ou 2 **caractérisé en ce que** le champ coercitif (Hc) du circuit magnétique est inférieur à 1,5 Ampères par mètre en statique ou en basse fréquence.

4. Dispositif de protection différentielle selon l'une quelconque des revendications 1 à 3 **caractérisé en ce que** le circuit magnétique du transformateur a un rapport champ coercitif sur induction à champ nul tel que le champ coercitif est inférieur (Hc) à 3A/m pour une induction à champ nul (Bh0) supérieure à 1 Tesla.

5. Dispositif de protection différentielle selon l'une quelconque des revendications 1 à 4 **caractérisé en ce que** la variation de l'induction du circuit magnétique du transformateur, en statique ou à une fréquence inférieure à 400Hz, est supérieure à 2 Teslas pour un champ magnétique inférieur à 3 Ampères par mètre (3 A/m).

6. Dispositif de protection différentielle selon la revendication 5 **caractérisé en ce que** la variation de l'induction du circuit magnétique du transformateur, en statique ou à une fréquence inférieure à 400Hz, est supérieure à 2,4 Teslas pour un champ magnétique inférieur à 2,5 Ampères par mètre (2,5 A/m).

7. Dispositif de protection différentielle selon l'une quelconque des revendications 1 à 6 **caractérisé en ce que** le circuit magnétique du transformateur a un champ magnétique inférieur à 20 Ampères par mètre (20 A/m) à induction nulle à une fréquence de trois kilohertz (kHz).

8. Dispositif de protection différentielle selon l'une quelconque des revendications 1 à 7 **caractérisé en ce que** le circuit magnétique est obtenu par un traitement thermique sous un champ magnétique.

9. Dispositif de protection différentielle selon l'une quelconque des revendications 1 à 8 **caractérisé en ce que** le matériau du circuit magnétique comporte plus de 50% de grains à fins cristaux ayant une grosseur de grains inférieure à 100nm.

10. Dispositif de protection différentielle selon l'une quelconque des revendications 1 à 9 **caractérisé en ce que** le matériau du circuit magnétique est réalisé par des bandes de matériaux ayant une épaisseur inférieure à 30 micromètres (µm).

11. Dispositif de protection différentielle selon l'une quelconque des revendications 1 à 10 **caractérisé en ce** le transformateur comporte un support (40) pour maintenir le matériau magnétique.

12. Dispositif de protection différentielle selon la revendication 11 **caractérisé en ce que** le matériau magnétique est enroulé en bandes sur le support (40), les bandes formant un circuit magnétique (2) d'épaisseur (41) inférieure à un millimètre.

13. Dispositif de protection différentielle selon l'une quelconque des revendications 1 à 10 **caractérisé en ce que** le circuit magnétique est constitué par au moins une rondelle de matériau magnétique.

14. Dispositif selon l'une quelconque des revendications 1 à 13 **caractérisé en ce que** le circuit (9) d'excitation comporte des moyens pour injecter dans l'enroulement (3) secondaire un courant (Ie, 15) de forme triangulaire, une excitation correspondant à une amplitude de crête dudit courant (Ie, 15) et à un nombre de spires de l'enroulement (3) étant inférieure à 3,5 ampère-tours.

15. Dispositif selon l'une quelconque des revendications 1 à 14 **caractérisé en ce que** le circuit d'alimentation fournit au circuit d'excitation et à l'enroulement secondaire une puissance inférieure à 1 Watt.

## Patentansprüche

1. Differenzstromschutzeinrichtung, die auf einen Differenzfehlerstrom in Form eines Wechselstroms, Gleichstroms oder periodischen Stroms anspricht und
- einen als Ringkernwandler ausgebildeten Differenzstromüberwachungswandler (1), der einen Magnetkreis und mindestens eine Sekundärwicklung (3) zur Beaufschlagung mit Erregungssignalen umfasst, die zur Detektion eines Differenzfehlerstroms durch Verschiebung des Magnetfelds des Magnetkreises dienen,
- einen an die genannte mindestens eine Sekundärwicklung des genannten Überwachungswandlers angeschlossene Erregerschaltung (9) zum Anlegen der genannten Erregungssignale,
- eine an die Sekundärwicklung und an die Erregerschaltung angeschlossene Verarbeitungsschaltung (4) sowie
- eine an die Erregerschaltung und an die Verarbeitungsschaltung angeschlossene Stromversorgungsschaltung (8) umfasst,
**dadurch gekennzeichnet, dass** der Magnetkreis des Wandlers aus einem ferromagnetischen Werkstoff mit Kristallen einer Komgröße unter 100 nm besteht,
wobei der genannte Magnetwerkstoff im statischen Betrieb oder bei niedrigen Frequenzen eine annähernd rechteckige Magnetisierungskennlinie (21, 23) und eine Koerzitivfeldstärke (Hc) von unter 3 Ampere pro Meter aufweist.

2. Differenzstromschutzeinrichtung nach Anspruch 1, **dadurch gekennzeichnet, dass** die Rechteckkennlinie des Magnetkreises (21, 23) so ausgebildet ist, dass das Verhältnis zwischen der magnetischen Induktion bei Feldstärke null (Bh0) und der Sättigungsinduktion (Bsat) größer als 0,95 ist.

3. Differenzstromschutzeinrichtung nach einem der Ansprüche 1 oder 2, **dadurch gekennzeichnet, dass** die Koerzitivfeldstärke (Hc) des Magnetkreises im statischen Betrieb oder bei niedrigen Frequenzen kleiner als 1,5 Ampere pro Meter ist.

4. Differenzstromschutzeinrichtung nach irgendeinem der Ansprüche 1 bis 3, **dadurch gekennzeichnet, dass** das Verhältnis zwischen Koerzitivfeldstärke und magnetischer Induktion bei Feldstärke null des Magnetkreises des Stromwandlers so ausgelegt ist, dass für eine magnetische Induktion bei Feldstärke null (Bh0) von über 1 Tesla die Koerzitivfeldstärke (Hc) unter 3 A/m beträgt.

5. Differenzstromschutzeinrichtung nach irgendeinem der Ansprüche 1 bis 4, **dadurch gekennzeichnet, dass** die Änderung der magnetischen Induktion des Magnetkreises des Stromwandlers im statischen Betrieb oder bei Frequenzen unter 400 Hz mehr als 2 Tesla bei einer Feldstärke unter 3 Ampere pro Meter (3 A/m) beträgt.

6. Differenzstromschutzeinrichtung nach Anspruch 5, **dadurch gekennzeichnet, dass** die Änderung der magnetischen Induktion des Magnetkreises des Stromwandlers im statischen Betrieb oder bei Frequenzen unter 400 Hz mehr als 2,4 Tesla bei einer Feldstärke unter 2,5 Ampere pro Meter (2,5 A/m) beträgt.

7. Differenzstromschutzeinrichtung nach irgendeinem der Ansprüche 1 bis 6, **dadurch gekennzeichnet, dass** der Magnetkreis des Stromwandlers bei einer Frequenz von drei Kilohertz (kHz) eine magnetische Feldstärke von unter 20 Ampere pro Meter (20 A/m) bei einer magnetischen Induktion von null hat.

8. Differenzstromschutzeinrichtung nach irgendeinem der Ansprüche 1 bis 7, **dadurch gekennzeichnet, dass** der Magnetkreis durch Wärmebehandlung in einem Magnetfeld hergestellt wird.

9. Differenzstromschutzeinrichtung nach irgendeinem der Ansprüche 1 bis 8, **dadurch gekennzeichnet, dass** der Werkstoff des Magnetkreises mehr als 50% Feinkristallkörner einer Korngröße von unter 100 nm umfasst.

10. Differenzstromschutzeinrichtung nach irgendeinem der Ansprüche 1 bis 9, **dadurch gekennzeichnet, dass** der Werkstoff des Magnetkreises aus Bändern einer Dicke von unter 30 Mikrometer (µm) hergestellt wird.

11. Differenzstromschutzeinrichtung nach irgendeinem der Ansprüche 1 bis 10, **dadurch gekennzeichnet, dass** der Wandler einen Tragkörper (40) zur Aufnahme des Magnetwerkstoffs umfasst.

12. Differenzstromschutzeinrichtung nach Anspruch 11, **dadurch gekennzeichnet, dass** der Magnetwerkstoff zu Bändern um den Tragkörper (40) gewickelt wird, wobei die Bänder einen Magnetkreis (2) mit einer Dicke (41) von unter einem Millimeter bilden.

13. Differenzstromschutzeinrichtung nach irgendeinem der Ansprüche 1 bis 10, **dadurch gekennzeichnet, dass** der Magnetkreis aus mindestens einer Ringscheibe aus einem Magnetwerkstoff besteht.

14. Differenzstromschutzeinrichtung nach irgendeinem der Ansprüche 1 bis 13, **dadurch gekennzeichnet, dass** die Erregerschaltung (9) Mittel zur Injektion eines Dreieckstroms in die Sekundärwicklung (3) umfasst, wobei eine Erregung entsprechend einem Scheitelwert der Amplitude des genannten Stroms (Ie, 15) und entsprechend einer bestimmten Anzahl von Windungen der Wicklung (3) unter 3,5 Amperewindungen beträgt.

15. Differenzstromschutzeinrichtung nach irgendeinem der Ansprüche 1 bis 14, **dadurch gekennzeichnet, dass** die Stromversorgungsschaltung eine Leistung von unter 1 Watt an die Erregerschaltung und an die Sekundärwicklung liefert.

## Claims

1. Earth leakage protection device sensitive to an AC, DC or periodic earth leakage fault current comprising:
- an earth leakage fault current detection transformer (1) in the form of a toroid comprising a magnetic circuit and at least one secondary winding (3) to receive excitation signals designed for earth leakage fault detection by shifting the magnetic field of the magnetic circuit,
- an excitation circuit (9) connected to said at least one secondary winding of said detection transformer to apply said excitation signals (Ie),
- a processing circuit (4) connected to the secondary winding and to the excitation circuit, and
- a power supply circuit (8) connected to the excitation circuit and to the processing circuit,
device **characterized in that** the magnetic circuit of the transformer is made of iron-based magnetic material having crystals of a size smaller than 100nm,
said magnetic material having, in static or low frequency cycle, a substantially rectangular magnetisation cycle (21, 23) and a coercive field (Hc) lower than 3 Amps per metre.

2. Earth leakage protection device according to claim 1 **characterized in that** the rectangular cycle (21, 23) of the magnetic circuit is such that the ratio of a zero field induction (Bh0) over a saturation induction (Bsat) is greater than 0.95.

3. Earth leakage protection device according to one of the claims 1 or 2 **characterized in that** the coercive field (Hc) of the magnetic circuit is less than 1.5 Amps per metre in static or low frequency cycle.

4. Earth leakage protection device according to any one of the claims 1 to 3 **characterized in that** the magnetic circuit of the transformer has a coercive field over zero field induction ratio such that the coercive field (Hc) is less than 3A/m for a zero field induction (Bh0) greater than 1 Tesla.

5. Earth leakage protection device according to any one of the claims 1 to 4 **characterized in that** the induction variation of the magnetic circuit of the transformer in static cycle or at a frequency less than 400 Hz is greater than 2 Teslas for a magnetic field lower than 3 Amps per metre (3 A/m).

6. Earth leakage protection device according to claim 5 **characterized in that** the induction variation of the magnetic circuit of the transformer in static cycle or at a frequency less than 400 Hz is greater than 2.4 Teslas for a magnetic field lower than 2.5 Amps per metre (2.5 A/m).

7. Earth leakage protection device according to any one of the claims 1 to 6 **characterized in that** the magnetic circuit of the transformer has a magnetic field lower than 20 Amps per metre (20 A/m) at zero induction at a frequency of three kilohertz (kHz).

8. Earth leakage protection device according to any one of the claims 1 to 7 **characterized in that** the magnetic circuit is obtained by thermal treatment in a magnetic field.

9. Earth leakage protection device according to any one of the claims 1 to 8 **characterized in that** the material of the magnetic circuit comprises more than 50% of fine crystal grains having a grain size of less than 100nm.

10. Earth leakage protection device according to any one of the claims 1 to 9 **characterized in that** the material of the magnetic circuit is achieved by strips of materials having a thickness of less than 30 micrometres (µm).

11. Earth leakage protection device according to any one of the claims 1 to 10 **characterized in that** the transformer comprises a support (40) to hold the magnetic material.

12. Earth leakage protection device according to claim 11 **characterized in that** the magnetic material is wound onto the support (40) in strips, the strips forming a magnetic circuit (2) with a thickness (41) of less than one millimetre.

13. Earth leakage protection device according to any one of the claims 1 to 12 **characterized in that** the magnetic circuit is formed by at least one washer made of magnetic material.

14. Device according to any one of the claims 1 to 13 **characterized in that** the excitation circuit (9) comprises means for applying a current (Ie, 15) of triangular form to the secondary winding (3), an excitation corresponding to a peak amplitude of said current (Ie, 15) and to a number of turns of the winding (3) being less than 3.5 Amp-turns.

15. Device according to any one of the claims 1 to 14 **characterized in that** the power supply circuit supplies a power of less than 1 Watt to the excitation circuit and the secondary winding.
